# EUROPÄISCHE PATENTSCHRIFT

(11) **EP 1 759 453 B1**
(45) Veröffentlichungstag und Bekanntmachung des Hinweises auf die Patenterteilung: **18.02.2009**
(21) Anmeldenummer: 05742930.0
(22) Anmeldetag: 02.06.2005
(51) Int. Cl.: H03D 7/14

(54) **VERFAHREN UND SCHALTUNGSANORDNUNG ZUR VERMEIDUNG VON STÖRIMPULSEN IM ZWISCHEN-FREQUENZSIGNAL SOWIE AM-EMPFÄNGER; ENTHALTEND EIN SOLCHES VERFAHREN BZW: EINE SOLCHE SCHALTUNGSANORDNUNG**
METHOD AND CIRCUIT ARRANGEMENT FOR PREVENTION OF INTERFERENCE IN AN INTERMEDIATE FREQUENCY SIGNAL AND AM RECEIVER COMPRISING SUCH A METHOD OR CIRCUIT ARRANGEMENT
PROCEDE ET ENSEMBLE CIRCUIT PERMETTANT D'EVITER DES IMPULSIONS PARASITES DANS LE SIGNAL A FREQUENCE INTERMEDIAIRE ET RECEPTEUR AM METTANT EN OEUVRE CE PROCEDE ET CONTENANT LEDIT ENSEMBLE CIRCUIT

(30) Priorität: 09.06.2004 EP 04102616
(43) Veröffentlichungstag der Anmeldung: 07.03.2007
(73) Patentinhaber: NXP B.V., 5656 AG Eindhoven (NL)
(72) Erfinder: KOHSIEK, C-H., c/o Philips Intel. Prop.&Stand.GmbH, 52066 Aachen (DE)
(74) Vertreter: Röggla, Harald
(86) Internationale Anmeldenummer: PCT/IB2005/051790
(87) Internationale Veröffentlichungsnummer: WO 2005/122391

(56) Entgegenhaltungen:
- EP-A- 0 961 398
- US-A1- 2003 223 017

## Beschreibung

Die Erfindung betrifft ein Verfahren und eine Schaltungsanordnung zur Vermeidung von Störimpulsen im Zwischenfrequenzsignal in einem einen Mischer enthaltenden AM-Empfänger, bei dem ein dem Mischer zugeführtes Hochfrequenzsignal beim Auftreten von Störungen ausgetastet wird. Die Erfindung betrifft ferner einen AM-Empfänger, enthaltend ein solches Verfahren bzw. eine solche Schaltungsanordnung.

Die US 2003/223017 A1 beschreibt einen Gilbert-Zelle-Mischer in bipolarer Technik zum Frequenzherabsetzen eines Zwischenfrequenzsignals in ein Basisbandsignal.

Bei der Austastung des Hochfrequenzsignals gemäß dem Oberbegriff entsteht ein Störimpuls im Zwischenfrequenzsignal, da dessen Amplitude während der durch das Austasten des Hochfrequenzsignals bedingten Unterbrechung wegen der Dämpfung der Filter abnimmt und somit eine Störung auch im später demodulierten Signal entsteht.

Bei dem erfindungsgemäßen Verfahren kann eine derartige Störung dadurch vermieden werden, dass während der Austastung des Hochfrequenzsignals ein für das Zwischenfrequenzsignal vorgesehenes Filter entdämpft wird.

Da ein Störimpuls bei der Durchleitung durch mehrere Zwischenfrequenzfilter gedehnt wird, ist bei dem erfindungsgemäßen Verfahren vorzugsweise vorgesehen, dass das im Ausgangskreis des Mischers liegende Filter entdämpft wird.

Eine besonders einfache Ausgestaltung des erfindungsgemäßen Verfahrens besteht darin, dass die Entdämpfung durch Zuschalten eines negativen Widerstandes erfolgt. Dämpfung ein zuschaltbarer negativer Widerstand vorgesehen. Um die Austastzeit und somit eine möglicherweise verbleibende Reststörung möglichst klein zu halten, kann die erfindungsgemäße Schaltungsanordnung derart ausgestaltet sein, dass das im Ausgangskreis des Mischers liegende Filter mit einer Einrichtung zur Entdämpfung vorgesehen ist.

Eine einfache Realisierung ist dadurch möglich, dass zur Entdämpfung ein negativer Widerstand zuschaltbar ist.

Eine besonders einfache Realisierung des negativen Widerstandes ist dadurch möglich, dass der negative Widerstand von zwei Verstärkern gebildet ist, deren Eingänge über je einen Spannungsteiler an je einen Anschluss des Filters angeschlossen sind und deren Ausgänge mit dem jeweils anderen Anschluss des Filters verbunden sind. Dabei ist vorzugsweise vorgesehen, dass die Verstärker von mindestens je einem Transistor gebildet sind, wobei in einer gemeinsamen Zuleitung der Betriebsspannung zu den Emittern der Transistoren ein Schalter vorgesehen ist und dass den Transistoren Impedanzwandler vorgeschaltet sind.

Mit dieser Realisierung des negativen Widerstandes wird der allgemein übliche symmetrische Aufbau des Ausgangskreises des Mischers berücksichtigt. Ferner wird dadurch ein über einen großen Amplitudenbereich konstanter negativer Widerstand erzielt.

Ausführungsbeispiele der Erfindung sind in der Zeichnung anhand mehrerer Figuren dargestellt und in der nachfolgenden Beschreibung näher erläutert. Es zeigt:
Fig. 1 eine schematische Darstellung des Ausführungsbeispiels und
Fig. 2 eine detailliertere Darstellung.

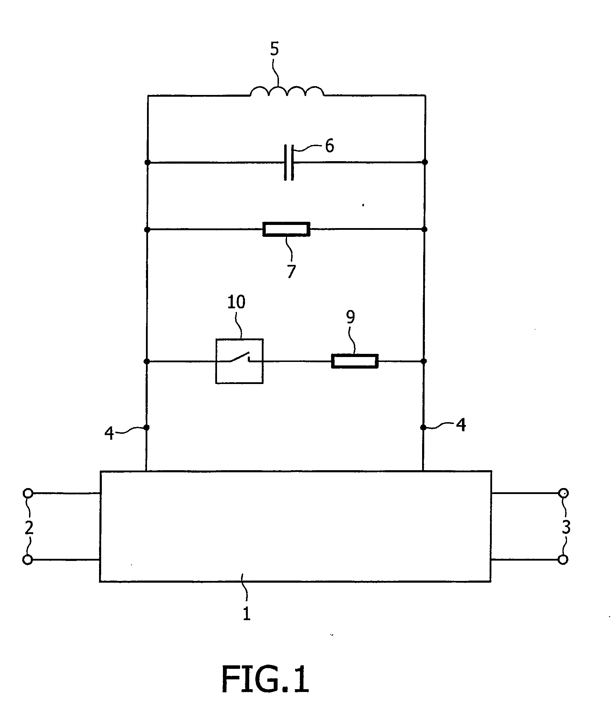

Fig. 1 zeigt einen an sich bekannten Mischer 1, dem über einen Eingang 2 das Hochfrequenzsignal und über einen weiteren Eingang 3 ein Oszillatorsignal zuführbar sind. An einem Ausgang 4, der ebenso wie die Eingänge 2, 3 symmetrisch ausgeführt ist, ist wie bei bekannten AM-Empfängern als Zwischenfrequenzfilter ein Schwingkreis angeschlossen, der aus einer Spule 5 und einem Kondensator 6 besteht. Stellvertretend für verschiedene dämpfende Komponenten des Schwingkreises 5, 6 ist bei der schematischen Darstellung nach Fig. 1 ein Widerstand 7 dargestellt.

Ohne weitere Maßnahmen vollführt der das Zwischenfrequenzfilter bildende Schwingkreis 5, 6, 7 bei Austastung des bei 2 zugeführten Hochfrequenzsignals eine gedämpfte Schwingung. Die ursprüngliche Amplitude wird erst wieder nach Einsetzen des Hochfrequenzsignals erreicht. Diese Störung macht sich im demodulierten Signal als Störimpuls bemerkbar. Um dies zu verhindern, ist bei der Schaltungsanordnung nach Fig. 1 ein negativer Widerstand 9 in Reihe mit einem Schalter 10 dem Schwingkreis 5, 6, 7 parallel geschaltet. Der negative Widerstand 9 ist derart ausgelegt, dass der Dämpfungswiderstand 7 praktisch kompensiert wird. Mit dem Zuschalten des negativen Widerstandes 9 entsteht somit ein Schwingkreis hoher Güte, wodurch die ZF-Amplitude auch während des Austastens des Hochfrequenzsignals nicht abnimmt.

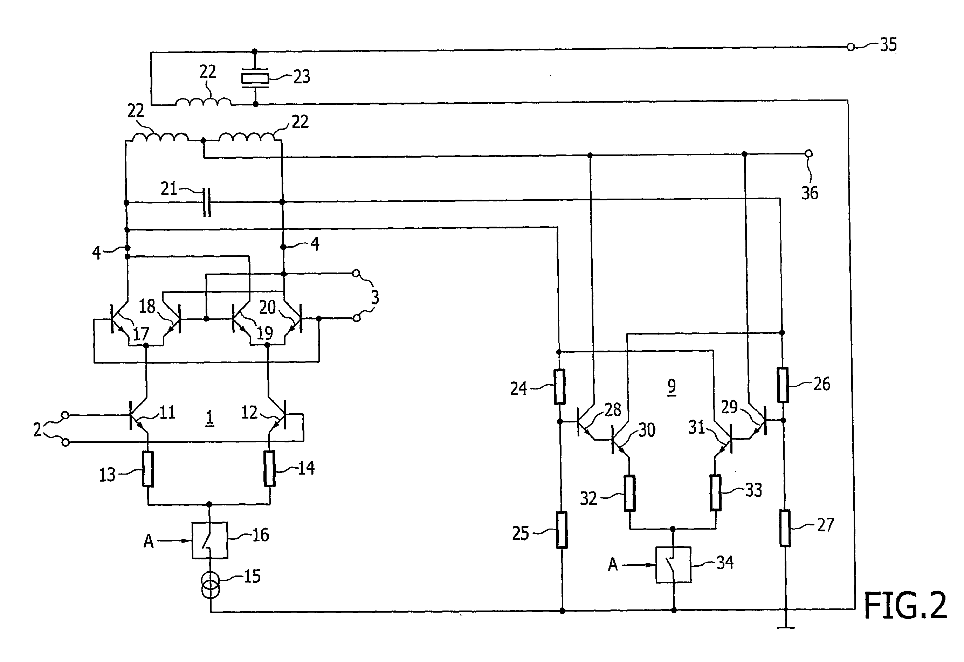

Die in Fig. 2 dargestellte Schaltungsanordnung enthält einen Mischer 1, der in an sich bekannter Weise symmetrisch in Form von Differenzverstärkern ausgebildet ist. Den Emittern von zwei ersten Transistoren 11, 12 wird über je einen Widerstand 13, 14 von einer Konstantstromquelle 15 Strom zugeführt, wobei zum Austasten des Hochfrequenzsignals, das bei 2 zugeführt wird, ein von einem Austastimpuls A gesteuerter Schalter 16 vorgesehen ist. An die Kollektoren der Transistoren 11, 12 sind Emitter jeweils eines Paars zweier Transistoren 17, 18; 19, 20 angeschlossen, wobei die Basisanschlüsse dieser Transistoren den Eingang 3 für die Oszillatorfrequenz bilden. Die Kollektoren der Transistoren 17, 19 bzw. 18, 20 bilden jeweils einen Pol des Ausgangs 4 des Mischers.

Das Zwischenfrequenzfilter wird bei diesem Ausführungsbeispiel von einem Kondensator 21, einem Transformator 22, sowie einem Keramikfilter 23 gebildet. Die eigentliche Filterfunktion übt das Keramikfilter 23 aus, während der von Induktivitäten des Transformators 22 und dem Kondensator 21 gebildete Schwingkreis neben dem Hauptdurchlassband des Keramikfilters 23 liegende Nebendurchlassbänder unterdrückt. Der Schwingkreis wird durch verschiedene Verluste innerhalb des Transformators und dessen Spulen sowie durch die Belastung mit dem Keramikfilter 23 gedämpft.

Zur Kompensation dieser Dämpfung ist ein negativer Widerstand 9 vorgesehen, der von zwei Verstärkern ausgebildet ist, wobei die Spannung an jeweils einen Anschluss des Schwingkreises über je einen Spannungsteiler 24, 25; 26, 27 der Basis je eines Emitterfolgers 28, 29 zugeführt wird, der mit jeweils einem Transistor 30, 31 kaskadiert ist. Die Kollektoren der Transistoren 30, 31 sind dann mit dem Schwingkreis verbunden. Der Emitterstrom der Transistoren 30, 31 wird über jeweils einen Widerstand 32, 33 und einen gemeinsamen vom Austastimpuls A gesteuerten Schalter 34 zugeführt. Ist dieser geschlossen, so ist der negative Widerstand aktiv und die Dämpfung des Schwingkreises 21, 22 vermindert. Einem Anschluss 35 kann das Zwischenfrequenzsignal zur weiteren Verarbeitung entnommen werden. Bei 36 wird positive Betriebsspannung zugeleitet.

## Patentansprüche

1. Verfahren zur Vermeidung von Störimpulsen im Zwischenfrequenzsignal in einem einen Mischer (1) enthaltenden AM-Empfänger, bei dem ein dem Mischer (1) zugeführtes Hochfrequenzsignal beim Auftreten von Störungen ausgetastet wird, wobei über die Emitter von zwei ersten Transistoren (11, 12) über je einen Widerstand (13, 14) von einer Konstantstromquelle (15) Strom zugeführt wird und zum Austasten des zugeführten (2) Hochfrequenzsignals ein von einem Austastimpuls (A) gesteuerter Schalter (16) vorgesehen ist, **dadurch gekennzeichnet, dass** während der Austastung des Hochfrequenzsignals ein für das Zwischenfrequenzsignal vorgesehenes Filter (5, 6, 7; 21, 22, 23) durch einen negativen Widerstand (9) in Reihe mit einem Schalter (10), der einem Schwingkreis (5, 6, 7) parallel geschaltet ist, entdämpft wird.

2. Schaltungsanordnung zur Vermeidung von Störimpulsen im Zwischenfrequenzsignal in einem einen Mischer (1) enthaltenden AM-Empfänger, bei dem ein dem Mischer (1) zugeführtes Hochfrequenzsignal beim Auftreten von Störungen ausgetastet wird, wobei über die Emitter von zwei ersten Transistoren (11, 12) über je einen Widerstand (13, 14) von einer Konstantstromquelle (15) Strom zugeführt wird und zum Austasten des zugeführten (2) Hochfrequenzsignals ein von einem Austastimpuls (A) gesteuerter Schalter (16) vorgesehen ist, **dadurch gekennzeichnet, dass** die Dämpfung eines für das Zwischenfrequenzsignal vorgesehenen Filters (5, 6, 7; 21, 22, 23) durch einen negativen Widerstand (9) in Reihe mit einem Schalter (10), der einem Schwingkreis (5, 6, 7) parallel geschaltet ist, herabsetzbar ist.

3. Schaltungsanordnung nach Anspruch 2, **dadurch gekennzeichnet, dass** der negative Widerstand von zwei Verstärkern (28, 30; 29, 31) gebildet ist, deren Eingänge über je einen Spannungsteiler (24, 25; 26, 27) an je einen Anschluss des Filters (21, 22) angeschlossen sind und deren Ausgänge mit dem jeweils anderen Anschluss des Filters (21, 22) verbunden sind.

4. Schaltungsanordnung nach Anspruch 3, **dadurch gekennzeichnet, dass** die Verstärker von mindestens je einem Transistor (30, 31) gebildet sind, wobei in einer gemeinsamen Zuleitung der Betriebsspannung zu den Emittern der Transistoren (30, 31) ein Schalter (34) vorgesehen ist.

5. Schaltungsanordnung nach Anspruch 4, **dadurch gekennzeichnet, dass** den Transistoren (30, 31) Impedanzwandler (28, 29) vorgeschaltet sind.

6. AM-Empfänger, **gekennzeichnet durch** eine Anwendung des Verfahrens nach Anspruch 1.

7. AM-Empfänger, **gekennzeichnet durch** eine Schaltungsanordnung nach einem der Ansprüche 2 bis 5.

## Claims

1. A method for the prevention of interference pulses in the intermediate frequency signal in an AM receiver comprising a mixer (1), in which a high frequency signal applied to the mixer (1) is blanked in the case of interference occurring, where current is supplied by a constant current source (15) via the emitters of two first transistors (11, 12) each via a resistor (13, 14) and a switch (16) controlled by a blanking pulse (A) is provided for blanking of the supplied high frequency signal (2), **characterized in that** during the blanking of the high frequency signal the attenuation of a filter (5, 6. 7; 21, 22, 23) arranged for the intermediate frequency signal is equalized by a negative resistance (9) connected in series with a switch (10) which is connected in parallel with the oscillation circuit (5, 6, 7).

2. A circuit arrangement for the prevention of interference pulses in the intermediate frequency signal in an AM receiver comprising a mixer (1), in which a high frequency signal applied to the mixer (1) is blanked in the case of interference occurring, where current is supplied by a constant current source (15) via the emitters of two first transistors (11, 12) each via a resistor (13, 14) and a switch (16) controlled by a blanking pulse (A) is provided for blanking of the supplied high frequency signal (2), **characterized in that** the attenuation of a filter (5, 6. 7; 21, 22, 23) arranged for the intermediate frequency signal can be reduced by a negative resistance (9) connected in series with a switch (10) which is connected in parallel with the oscillation circuit (5, 6, 7).

3. A circuit arrangement as claimed in claim 2, **characterized in that** the negative resistance is formed by two amplifiers (28, 30; 29, 31) whose inputs are connected via a respective voltage divider (24, 25; 26, 27) to a respective terminal of the filter (21, 22) and whose outputs are connected to the respective other terminal of the filter (21, 22).

4. A circuit arrangement as claimed in claim 3, **characterized in that** the amplifiers are formed by at least one transistor (30, 31), a switch (34) being provided in a common supply line of the operating voltage to the emitters of the transistors (30, 31).

5. A circuit arrangement as claimed in claim 4, **characterized in that** impedance converters (28, 29) are arranged upstream of the transistors (30, 31).

6. An AM receiver **characterized by** an implementation of the method as claimed in claim 1.

7. An AM receiver **characterized by** a circuit arrangement as claimed in any one of the claims 2 to 5.

## Revendications

1. Procédé permettant d'éviter des impulsions parasites dans un signal à fréquence intermédiaire dans un récepteur en modulation d'amplitude comprenant un mélangeur (1), dans lequel le signal haute fréquence délivré dans le mélangeur (1) est supprimé lors de l'occurrence d'interférences, un courant étant délivré via l'émetteur de deux premiers transistors (11, 12) chaque fois par l'intermédiaire d'une résistance (13, 14) d'une source de courant constant (15), un commutateur (16) commandé par une impulsion de suppression (A) étant prévu pour supprimer le signal haute fréquence délivré (2), **caractérisé en ce que** pendant la suppression du signal haute fréquence, un filtre prévu pour le signal de fréquence intermédiaire (5, 6, 7 ; 21, 22, 23) est compensé par l'intermédiaire d'une résistance négative (9) en série avec un commutateur (10), lequel est monté en parallèle avec un circuit oscillant (5, 6, 7).

2. Agencement de commutateur permettant d'éviter des impulsions parasites dans un signal de fréquence intermédiaire dans un récepteur en modulation d'amplitude comprenant un mélangeur (1), dans lequel le signal haute fréquence délivré dans le mélangeur (1) est supprimé lors de l'occurrence d'interférences, un courant étant délivré via l'émetteur de deux premiers transistors (11, 12) chaque fois par l'intermédiaire d'une résistance (13, 14) d'une source de courant constant (15), un commutateur (16) commandé par une impulsion de suppression (A) étant prévu pour supprimer le signal haute fréquence délivré (2), **caractérisé en ce que** l'atténuation d'un filtre (5, 6, 7 ; 21, 22, 23) prévu pour le signal de fréquence intermédiaire peut être réduite par une résistance négative (9) en série avec un commutateur (10), lequel est monté en parallèle avec un circuit oscillant (5, 6, 7).

3. Agencement de commutateur selon la revendication 2, **caractérisé en ce que** la résistance négative est formée de deux amplificateurs (28, 30 ; 29, 31) dont chaque entrée est connectée à un diviseur de tension (24, 25 ; 26 ; 27) au niveau d'une connexion du filtre (21, 22) et dont les sorties sont reliées à l'autre connexion du filtre (21, 22).

4. Agencement de commutateur selon la revendication 3, **caractérisé en ce que** l'amplificateur est formé d'au moins un transistor (30, 31), un commutateur (34) étant prévu dans le câble d'alimentation commun de la tension d'alimentation vers les émetteurs des transistors (30, 31).

5. Agencement de commutateur selon la revendication 4, **caractérisé en ce que** des transformateurs d'adaptation d'impédance (28, 29) sont placés en amont des transistors (30, 31).

6. Récepteur en modulation d'amplitude, **caractérisé par** une mise en oeuvre du procédé selon la revendication 1.

7. Récepteur en modulation d'amplitude, **caractérisé par** un agencement de commutateur selon l'une quelconque des revendications 2 à 5.
